# EUROPEAN PATENT APPLICATION

(11) **EP 3 067 615 A1**
(43) Date of publication of application: **14.09.2016**
(21) Application number: 14860947.2
(22) Date of filing: 03.11.2014
(51) Int. Cl.: F21S 2/00, F21V 5/00, F21V 19/00, F21Y 101/00

(54) **THREE-PRIMARY COLOUR LED LAMP WITH DIFFERENT LIGHT-EMITTING SURFACES**

(30) Priority: 06.11.2013 CN 201310547647
(71) Applicant: Li, Chao, Zhengzhou, Henan 450008 (CN)
(72) Inventor: KANG, Xianbin, Zhengzhou Henan 450001 (CN); SHI, Daxin, Zhengzhou Henan 450001 (CN); LI, Shuzheng, Zhengzhou Henan 450001 (CN); SONG, Xinli, Zhengzhou Henan 450001 (CN)
(74) Representative: Hryszkiewicz, Danuta
(86) International application number: PCT/CN2014/090170
(87) International publication number: WO 2015/067150

(57) **Abstract**

A three-primary colour LED lamp with different light-emitting surfaces, which has three primary colours, i.e. RGB. The surface curvatures of the light-emitting surfaces of each lamp of the RGB lamp are different. The light-emitting surfaces are variable-radius light-emitting surfaces. The refraction angles of all lamps of the three-primary colour, i.e. RGB, lamp on the light-emitting surfaces coincide. Different light-emitting surfaces are used to compensate for different refraction angles when directions of light deviating from a normal are different, so that when RGB light with different wavelengths passes through the light-emitting surfaces, the light emitted at any angle does not generate a difference due to different refraction angles.

## Description

The invention relates to an LED light, and more particularly to an LED light comprising RGB lights having different light-emitting surfaces.

Typically, a RGB LED light includes a red light, a green light, and a blue light. In general, the light-emitting surfaces of the three lights have the same curvature. As a result, the refraction paths of the three lights have different directions and do not coincide, which produces inhomogeneous optical effects when the lights are viewed from different viewing angles.

In view of the above-described problems, it is one objective of the invention to provide a RGB LED light comprising three lights. The three lights, that is, a Red (R) light, a Green (G) light, and a Blue (B) light, have different light-emitting surfaces from another, which can compensate for different refraction angles of RGB lights, and thus the refraction angles of the three lights on corresponding light-emitting surface are coincident.

To achieve the above objective, in accordance with one embodiment of the invention, there is provided an LED light, comprising: a red (R) light, a green (G) light, and a blue (B) light. Each light includes a light-emitting surface. The surface curvatures of light-emitting surfaces of three lights are not equal to one another, and radiuses of light-emitting surfaces of three lights are variable; refraction angles of the three lights on corresponding light-emitting surface are coincident. In particular, the radiuses of the light-emitting surfaces of the three lights are variable and are different from one another.

Preferably, the three lights each comprise two LED chips, and the two LED chips are symmetrically arranged on two sides of a normal.

Preferably, the light-emitting surfaces are arc surfaces or ellipsoidal surfaces.

According to basic knowledge of optics, among RGB lights, the R light (red light) has the longest wave length and thereby the shortest curvature radius; the B light (blue light) has the shortest wave length and thereby the longest curvature radius; and the G light (green light) is intermediate between the R light and the G light, and relatively closer to the B light.

According to the law of optics, the refractive index of a medium to the light is *n=c*/*v,* where *n* is the refractive index, c is the velocity of light, and *v* is the actual propagation velocity. The transmitting frequency of a light in a medium is constant, and the relationship between a velocity and a wave length thereof is *v=f*λ,* where f is the frequency, and λ is the wave length.

Therefore, *n=λ_{σ}*/*λᵥ.*

And refractive indexes of two mediums *n₁*/*n₂=λ₂*/*λ₁.* i.e., the longer the wave length is, the smaller the refractive index is.

The wavelengths of the RGB lights are not necessarily the same, and the following frequently-used data are used as examples to specify that the RGB LED light can be fabricated with random wavelengths:
λ*_{R}*=620-630 nm, and 625 nm is taken;
*λ_{G}*=520-530 nm, and 525 nm is taken;
*λ_{B}*=465-475 nm, and 470 nm is taken;
thus n_{R}/n_{G}=625/525=1.190;
n*_{G}*/n*_{B}*=525/470=1.117; and
n*_{R}*/n*_{B}*=625/470=1.330.

Therefore, the refractive index of the R light is the smallest. The refractive index of the G light is 1.241 times as much as the refractive index of the R light, and the refractive index of the B light is 1.330 times as much as the refractive index of the R light. The LED chips fabricated by different factories have different wavelengths; in addition, different package media lead to different refractive indexes, too.

According to the basic knowledge and laws of optics, the light-emitting surfaces having different curvatures can be designed as needed. In line with the formula of optics: sin*i*/sin*y*=*n* (n is a constant), where *i* is an incident angle, *y* is a refraction angle, the sine of the incident angle is proportional to the sine of the refraction angle, but the incident angle is not proportional to the refraction angle; however, when an angle of a display changes, a refraction angle of lights emitted by the display is required to be proportional to (or nearly proportional to) an optic angle of lights emitted by the display, instead of a sine of the refraction angle to a sine of the optic angle, thus, a curvature radius of the light-emitting surfaces is provided. Distances from the chips on the left or on the right to the package surface are adjustable, and distances from the chips on the left to the chips on the right are also adjustable.

The refractive index of the package medium of the LED light ranges from 1.2 to 2, primarily between 1.4 and 1.7, and mostly between 1.5-1.65. Package media and LED lights having arbitrary refractive index are practicable in the invention.

Advantages of the LED light according to embodiments of the invention are summarized as follows:

The LED light employs light-emitting surfaces having curvature radiuses, which can compensate for different refraction angles of RGB lights, so that the refraction angles of the RGB lights are coincident. Based on the RGB LED light of the invention, a naked-eye LED display can be correctly and precisely performed, the viewing angle of naked-eyes is expanded, and the visual clarity is greatly improved from every angle without interference.
FIG. 1 is a diagram showing refractions of RGB lights of a conventional LED light of which the curvatures of light-emitting surfaces are the same;
FIG. 2 is a diagram showing a change of a refraction angle *θ*₂ in line with the change of an incident angle *θ*₁ when the curvatures of light-emitting surfaces of an LED light are the same in the prior art;
FIG. 3 is a diagram showing that refraction paths of RGB lights of an LED light having different curvature radiuses coincide in accordance with one embodiment of the invention;
FIG. 4 is a structural diagram showing flat-shaped RGB lights having negative poles inside and positive poles outside in accordance with one embodiment of the invention;
FIG. 5 is a structural diagram showing flat-shaped RGB lights having negative poles inside and positive poles outside in accordance with one embodiment of the invention;
FIG. 6 is a schematic diagram of an LED light having an ellipsoidal shape in accordance with one embodiment of the invention; and
FIG. 7 is a schematic diagram of an LED light having an ellipsoidal shape and an ellipsoidal light-emitting surface in accordance with one embodiment of the invention.

The LED light optionally has three or four feet; when the LED light has three feet, two feet in the middle are integrated inside as one, then introduced outwards.

For further illustrating the invention, experiments detailing an LED light comprising RGB lights having different light-emitting surfaces are described below. It should be noted that the following examples are intended to describe and not to limit the invention.

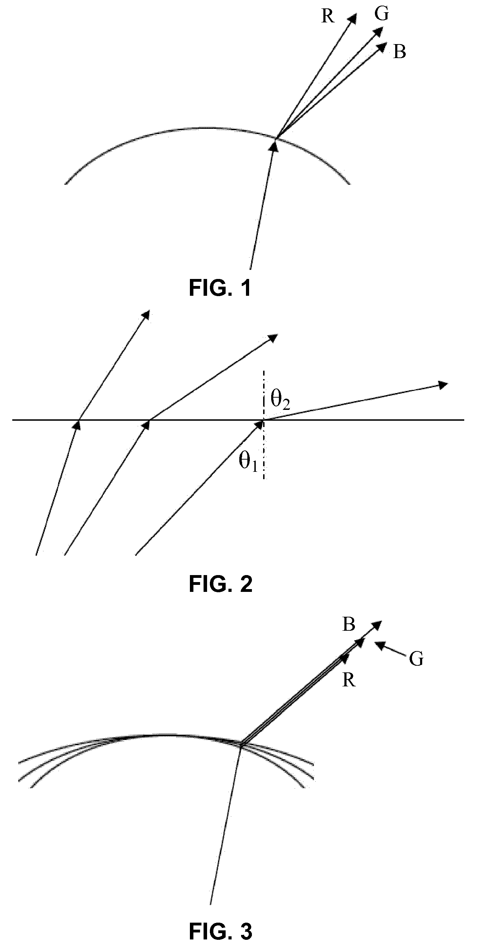

FIG. 1 is a diagram showing refractions of RGB lights of a conventional LED light where the curvature radiuses of the light-emitting surfaces of the RGB lights are the same, where an R light (red light) has the smallest refraction angle; a B light (blue light) has the largest refraction angle; and the refraction angle of a G light (green light) is intermediate between the R light and the G light. FIG. 2 is a diagram showing a change of a refraction angle *θ*₂ in line with the change of an incident angle *θ*₁ when the curvatures of light-emitting surfaces of an LED light are the same. In production, the curvature radius increases in line with the increase of the incident angle. Thus, the light-emitting surfaces have a curvature radius. By calculating curvature radiuses according to refractive indexes of different package media, refraction angles of RGB lights from any angle coincide or approximately coincide, as shown in FIG. 3.

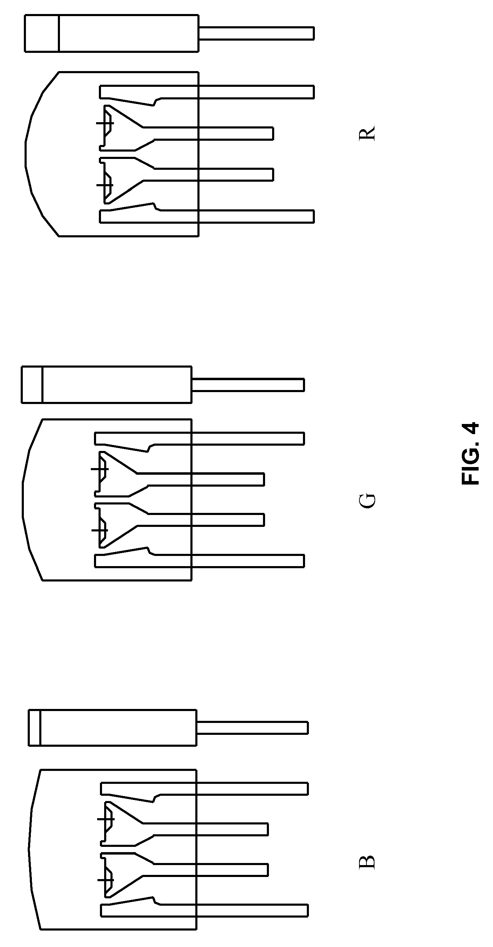

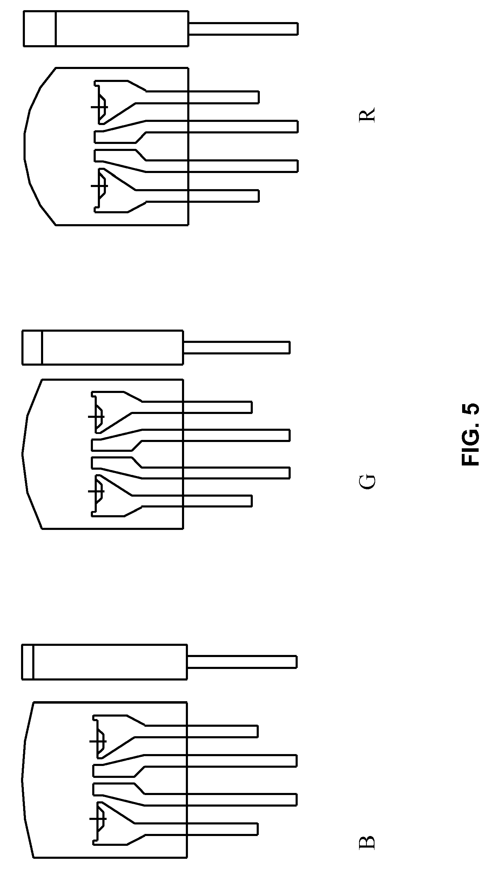

As shown in FIGS. 4-7, the light body of the LED light is flat-shaped or ellipsoidal, and the light-emitting surfaces are arc surfaces having a curvature radius, or ellipsoidal surfaces having a curvature radius. FIGS. 4-5 are structural diagrams showing that the flat-shaped RGB lights comprise negative poles inside and positive poles outside, or that the flat-shaped RGB lights comprise positive poles inside and negative poles outside. Shapes of the RGB lights are basically the same, and light-emitting surfaces of the RGB lights have a curvature radius, but curvature radiuses of the RGB lights are different from one another, where an R light has the shortest curvature radius, a B light has the longest curvature radius, and a G light is intermediate between the R light and the G light. The RGB lights each comprise two light-emitting chips inside, and the two LED chips are symmetrically arranged on two sides of a normal. The two-chip LED light is horizontally arranged on a circuit board, for the purpose of light-emitting of left-eye and right-eye image data.

Two chips inside each light are symmetrically arranged, and two poles in the middle which have the same polarity are introduced outwards respectively (four feet); or the two poles are integrated inside as one, then introduced outwards (three feet). The poles are positive inside and negative outside, or are negative inside and positive outside.

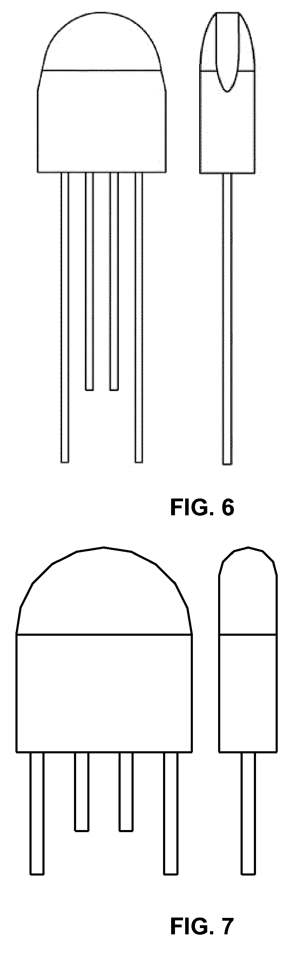

As shown in FIG. 6, the light body is ellipsoidal, and a light-emitting surface thereof is an arc surface. As shown in FIG. 7, the light-emitting surface can also be concave, convex, or ellipsoidal. Irrespective of the shape, the radius of the light-emitting surface varies with position along the surface.

### Best modes

FIG. 1 is a diagram showing refractions of RGB lights of a conventional LED light where the curvatures of the light-emitting surfaces of the RGB lights are the same, where an R light (red light) has the smallest refraction angle; a B light (blue light) has the largest refraction angle; and a refraction angle of a G light (green light) is intermediate between the R light and the G light. FIG. 2 is a diagram showing a change of a refraction angle *θ*₂ in line with the change of an incident angle *θ*₁ when the curvatures of light-emitting surfaces of an LED light are the same. In production, a curvature radius increases in line with an incident angle, thus the light-emitting surfaces have a variable radius; by calculating curvature radiuses according to refractive indexes of different package media, refraction angles of RGB lights from any angle coincide or nearly coincide, as shown in FIG. 3.

As shown in FIGS. 4-7, the light body of the LED light is flat-shaped or ellipsoidal, and the light-emitting surfaces are arc surfaces having a variable radius, or ellipsoidal surfaces having a variable radius. FIGS. 4-5 are structural diagrams showing that the flat-shaped RGB lights comprise negative poles inside and positive poles outside, or that the flat-shaped RGB lights comprise positive poles inside and negative poles outside. Shapes of the RGB lights are basically the same, and light-emitting surfaces of the RGB lights have a variable radius, but curvature radiuses of the RGB lights are different from one another, where an R light has the shortest curvature radius, a B light has the longest curvature radius, and a G light is intermediate between the R light and the G light. The RGB lights each comprise two light-emitting chips inside, and the two LED chips are symmetrically arranged on two sides of a normal. The two-chip LED light is horizontally arranged on a circuit board, for the purpose of light-emitting of left-eye and right-eye image data.

Two chips inside each light are symmetrically arranged, and two poles in the middle which have the same polarity are introduced outwards respectively (four feet); or the two poles are integrated inside as one, then introduced outwards (three feet). The poles are positive inside and negative outside, or are negative inside and positive outside.

As shown in FIG. 6, the light body is ellipsoidal, and a light-emitting surface thereof is an arc surface. As shown in FIG. 7, the light-emitting surface could also be concave, convex, or ellipsoidal. Whatever the shape is, the light-emitting surface has a variable radius.

While particular embodiments of the invention have been shown and described, it will be obvious to those skilled in the art that changes and modifications may be made without departing from the invention in its broader aspects, and therefore, the aim in the appended claims is to cover all such changes and modifications as fall within the true spirit and scope of the invention.

### Industrial applicability

The LED light employs light-emitting surfaces having a variable radius, which can compensate for different refraction angles of RGB lights, so that the refraction angles of the RGB lights are coincident. Based on the RGB LED light of the invention, a naked-eye LED display can be correctly and precisely performed, the viewing angle of naked-eyes is expanded, and the visual clarity is greatly improved from every angle without interference.

## Claims

1. An LED light, comprising: a red (R) light, a green (G) light, and a blue (B) light, each light having a light-emitting surface;
**characterized in that**
surface curvatures of light-emitting surfaces of three lights are not equal to one another, and radiuses of light-emitting surfaces of three lights are variable; refraction angles of the three lights on corresponding light-emitting surface are coincident.

2. The light of claim 1, **characterized in that** the three lights each comprise two LED chips, and the two LED chips are symmetrically arranged on two sides of a normal.

3. The light of claim 1 or 2, **characterized in that** the light-emitting surfaces are arc surfaces or ellipsoidal surfaces.
